Europäisches Patentamt

European Patent Office

Office européen des brevets

(11) Publication number: **0 316 914**
**A2**

# EUROPEAN PATENT APPLICATION

(21) Application number: 88119140.7

(22) Date of filing: 17.11.88

(51) Int. Cl.4: **H03K 17/95**

(30) Priority: 17.11.87 JP 289833/87

(43) Date of publication of application:
**24.05.89 Bulletin 89/21**

(84) Designated Contracting States:
**AT BE CH DE ES FR GB GR IT LI LU NL SE**

(71) Applicant: **OMRON TATEISI ELECTRONICS CO.**
**10, Tsuchido-cho Hanazono Ukyo-ku**
**Kyoto 616(JP)**

(72) Inventor: **Ueda, Kenji c/o Omron Tateisi Electronics Co.**
**Patent Center 20, Igadera, Shimo-Kaiinji Nagaokakyo-City Kyoto 617(JP)**

(74) Representative: **WILHELMS, KILIAN & PARTNER Patentanwälte et al**
**Eduard-Schmid-Strasse 2**
**D-8000 München 90(DE)**

(54) High-frequency oscillation type proximity switch.

(57) A high-frequency oscillation type proximity switch include a high frequency oscillation circuit, circuit, an excitation coil driven by a signal produced from the high frequency oscillation circuit, a compensating coil producing a voltage having a substantially same potential as that produced from the excitation coil, a differential amplifier circuit for differentially amplifying the voltages produced from the excitation coil and the compensating coil so as to produce a voltage corresponding to a voltage produced by the excitation coil as a piece of metal approaches the proximity switch to be flowed by an eddy current, a phase-shifting circuit for shifting a phase of an output signal from the high-frequency oscillation circuit by a predetermined angle, a pulse generating circuit for generating a pulse having a predetermined cycle, a sampling circuit for sampling and holding an output from the differential amplifier circuit by the pulse from the pulse generating circuit, and a comparator circuit for comparing an output from the sampling circuit with a reference level for determining whether or not the output from the sampling circuit exceed the level.

Xerox Copy Centre

## HIGH-FREQUENCY OSCILLATION TYPE PROXIMITY SWITCH

### Background of the Invention

#### 1. Field of the Invention

This invention relates to a high-frequency type proximity switch, and more particularly to an improved proximity switch capable of sensing an existence or characteristics of a piece of metal at a high accuracy.

#### 2. Discussion of the Related Art

In a conventional electronic high-frequency type proximity switch including a high-frequency oscillation circuit having a sensing coil, as a piece of metal approaches the sensing coil, the amplitude or frequency of the oscillation developed in the oscillation circuit varies so that the piece of metal is sensed concerning its approach or material by detecting such a variation of the oscillation. A variation of the oscillation amplitude in such a conventional proximity switch is detected by finding a variation of a loss resistance of the sensing coil, and a variation of the oscillation frequency is detected in finding a variation of a reactance of the coil.

Thus, the conventional high frequency oscillation type proximity switch detects the variation of the loss resistance or reactance of the sensing coil, in which as a high frequency magnetic field is applied to the piece of metal, an eddy current having a phase in accordance with the characteristics of the metal (the difference of the electric conductivities, magnetic permeabilities and so forth) and the frequency of the applied high frequency magnetic field occurs. Accordingly, a voltage developed in the coil by the eddy current, viz. the effect on the coil by the eddy current in the metal, does not coincide with the loss resistance and the reactance. Moreover, since the loss resistance and reactance of the coil may vary in accordance with a temperature applied to the metal, it is difficult to separate the variation by the temperature from the variation by the eddy current, so that the temperature characteristics is unstable.

### Summary of the Invention

It is, therefore, a primary object of this invention to provide high-frequency oscillation type proximity switch which detects a voltage component itself developed by an eddy current flowing through a piece of metal so as to detect an existence or characteristic of the piece of metal with high stable accuracy.

In accordance with an example of a preferred embodiment of this invention, there is provided a high-frequency oscillation type proximity switch including a high frequency oscillation circuit, an excitation coil driven by a signal produced from the high frequency oscillation circuit, a compensating coil producing a voltage having a substantially same potential as that produced from the excitation coil, a differential amplifier circuit for differentially amplifying the voltages produced from the excitation coil and the compensating coil so as to produce a voltage corresponding to a voltage produced by the excitation coil as a piece of metal approaches the proximity switch to be flowed by an eddy current, a phase-shifting circuit for shifting a phase of an output signal for the high-frequency oscillation circuit by a predetermined angle, a pulse generating circuit for generating a pulse having a predetermined cycle, a sampling circuit for sampling and holding an output from the differential amplifier circuit by the pulse from the pulse generating circuit, and a comparator circuit for comparing an output from the sampling circuit with a reference level to determining whether or not the output from the sampling circuit exceed the level.

The high-frequency oscillation type proximity switch according to this invention employs the following principle:

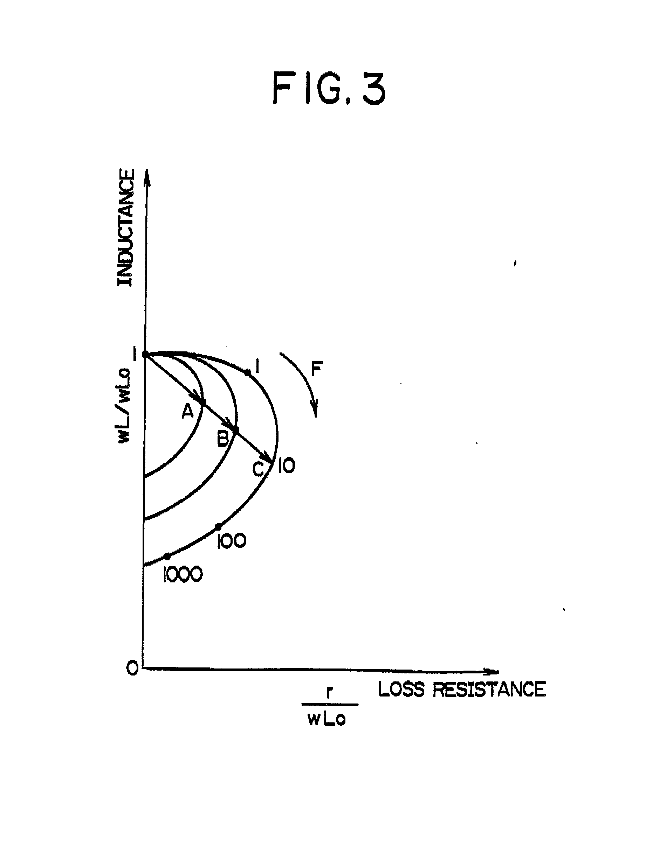

Generally, a normalized impedance of the variations of an impedance ($\omega L$) of a coil which is approached by a piece of metal on the basis of an impedance ($\omega Lo$: loss is neglected) of the coil which is not approached by the piece of metal is represented by vector curves shown in Fig. 3. Whose ordinate represents variations of inductance ($\omega L/\omega Lo$) and whose abscissa represents variations of loss resistance ($R/\omega Lo$). Mark F in Fig. 3 shows a normalized frequency and is represented by the equation $F = 2\pi f \mu_1 \sigma_1 r^2$ (f: excitation frequency, $\mu_1$: magnetic permeability of metal, r: radius of coil, $\sigma_1$ electric conductivity of metal).

Assuming that a piece of metal approaches under the condition of the normalized frequency $F = 10$, a variation of the impedance increases in the direction A→B→C as the piece of metal approaches. The voltage produced by applying a high frequency constant current i to the coil is given by multiplying the normalized impedance by a constant $\omega Loi$. In other words, Fig. 3 may represent a voltage vector induced by the coil.

The voltage induced by the coil is added by voltages according to eddy currents $\overrightarrow{1A}$, $\overrightarrow{1B}$ and $\overrightarrow{1C}$ in proportion to approach by a piece of metal into a reference vector $\overrightarrow{01}$, and changed to voltages $\overrightarrow{OA}$, $\overrightarrow{OB}$ and $\overrightarrow{OC}$. Accordingly, the voltage $\overrightarrow{01}$ is obtained at a higher S/N ratio by cancelling a voltage component of the reference voltage $\overrightarrow{01}$ and detecting only the vector directions $\overrightarrow{1A}$, $\overrightarrow{1B}$ and $\overrightarrow{1C}$ than by detecting the variation $\overrightarrow{OA}$, $\overrightarrow{OB}$ and $\overrightarrow{OC}$.

In the high-frequency oscillation type proximity switch according to this invention employing the above described principle, when a piece of metal does not yet approach, a constant current generated from the oscillation circuit is so applied to the excitation and compensating coils to cancel the voltages generated from the both coils by the differential amplifier circuit which generates almost a zero voltage. If the piece of metal reaches a predetermined distance, an eddy current is generated in the piece of metal by a magnetic flux from the excitation coil to add a voltage caused by the eddy current into the excitation coil, so that a difference voltage between excitation and compensating coils is produced from the differential amplifier circuit. At the same time, the phase-shifting circuit shifts a high frequency signal from the oscillator circuit by a predetermined angle corresponding to a normalized frequency F, and the pulse generat ing circuit generates a sampling pulse to drive the sampling circuit so as to sample and hold an output from the differential amplifier circuit. The output from the circuit corresponds to $\overrightarrow{1A}$, $\overrightarrow{1B}$ and $\overrightarrow{1C}$ shown in Fig. 3 which is compared with the reference level by the comparator circuit to determine whether it exceeds the level, viz., whether a piece of metal approaches.

## Brief Description of the Drawings

The above and other objects, advantages and features of this invention will be more fully understood from the following detailed description of the invention which is provided in conjunction with the following drawings, of which:

Fig. 1 is a schematic circuit diagram of a preferred embodiment of a high-frequency oscillation type proximity switch according to this invention;

Fig. 2 shows waves forms to illustrate an operation of the proximity switch of Fig. 1; and

Fig. 3 illustrates variations of a normalized impedance of a coil approached by a piece of metal to explain a principle employed in the proximity switch.

## Detailed Description of the Invention

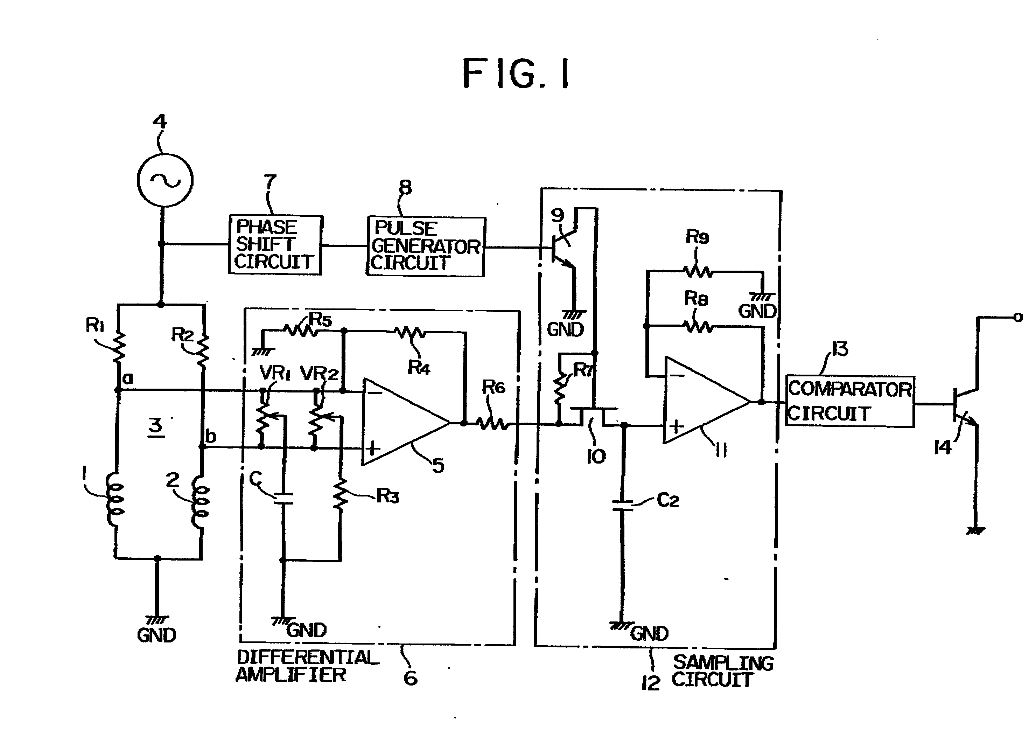

Referring to Fig. 1, there is shown a circuit diagram of a preferred embodiment of a high-frequency oscillation type proximity switch according to this invention, which includes an excitation coil 1, an compensating coil 2, and a pair of resistors $R_1$ and $R_2$ ($R_1 = R_2 = R$) to constitute a bridge connection circuit 3. Both of the coils 1 and 2 have a same construction. The bridge connection circuit 3 is interposed between a ground GND and a high frequency oscillation circuit 4. The excitation coil 1 is disposed toward approach by a piece of metal, while the compensating coil 2 is disposed free from a magnetic field generated by an eddy current in the approaching piece of metal. A connection point a of resistor $R_1$ and coil 1 is connected with a minus input terminal of an operational amplifier 5, and a connection point b of resistor $R_2$ and coil 2 is connected with a plus input terminal of the amplifier. A pair of variable resistors $V_{R1}$ and $V_{R2}$ are connected across the plus and minus input terminals of the amplifier 5 and grounded through a capacitor $C_1$ and a resistor $R_3$, so that unbalance by a distributed capacity and so forth is compensated. The minus input terminal of amplifier 5 is also grounded through a resistor $R_5$ and connected to an output terminal of the amplifier through a resistor $R_4$. Thus, a differential amplifier circuit 6 is constructed by amplifier 5, resistors $R_4$ and $R_5$, and so forth.

The output terminal of the operational amplifier 5 is connected to a plus input terminal of an operational amplifier 11 through a resistor $R_6$ and a field effect type transistor 10. A changing capacitor $C_2$ is connected between a plus input terminal of the amplifier 11 and the ground GND. A gate electrode of the field effect type transistor 10 is grounded through a NPN type transistor 9. A minus input terminal of the amplifier 11 is connected an output terminal thereof via a resistor $R_8$ and grounded via a resistor $R_9$. Thus, a sampling circuit 12 is constructed by transistors 9 and 10, capacitor $C_2$ and amplifier 11.

An output of the high frequency 4 is also applied to a phase shifting circuit 7 which shifts the phase of a high frequency signal applied thereto by a predetermined phase angle. In response to an output from the phase shifting circuit 7, a pulse generating circuit 8 generate a pulse signal which turns on the transistor 9.

An output of the operational amplifier 11 is applied a comparator circuit 13 which compares the applied output with a reference level to produce a high signal "logic 1" and turn on an output transistor 14 when the applied output is higher than the reference level.

An operation of the high frequency oscillation type proximity switch will be described hereinafter.

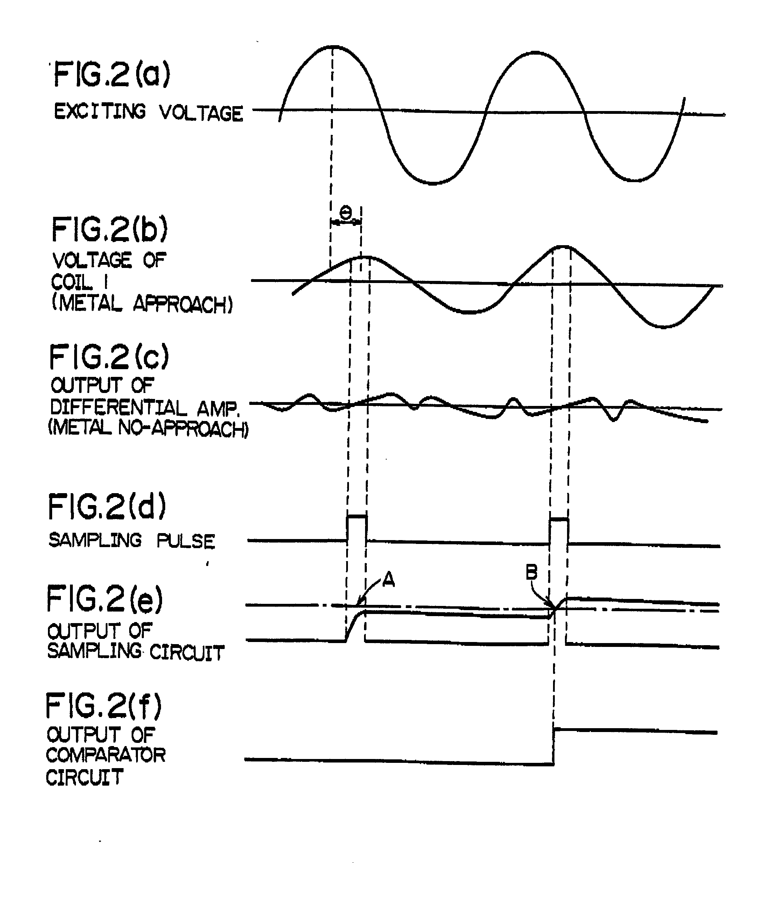

As a power source is applied, the high frequency oscillation circuit 4 starts and the exciting coil is excited by an exciting voltage as shown in Fig. 2 (a). In case that no piece of metal approaches near the excitation coil 1, the coil 1 generates a voltage only induced by its self exciting magnetic field which is substantially same as a voltage produced in the compensating coil 2, so that the output from the amplifier 5 is generated on the basis of a difference voltage between voltages at points a and b. Accordingly, the voltage generated in the excitation coil 1 is cancelled by the voltage produced in the compensation coil 2, an output produced from the differential amplifier circuit 6 is almost zero as shown in Fig. 2 (C). Variation of the level around zero is based on an unbalance of characteristics of the pair of coils 1 and 2. Such an output from the amplifier circuit 6 does not raise the input of the comparator circuit 13 higher than the reference level and the output transistor 14 is not turned on though the sampling circuit 12 samples the output from the amplifier circuit 6 in response to the pulse signal from the pulse generating circuit 8.

As the piece of metal approaches the excitation coil 1, an eddy current flows in the piece of metal due to variation of an exciting magnetic field and a voltage as shown in Fig. 2 (b) is induced in the exciting coil 1 by a magnetic field generated by the eddy current. The voltage induced by the eddy current has a phase shifted by $\theta$ with respect to excitation voltage. The voltage by the eddy current in the piece of metal is not induced in the compensating coil 2, so that the voltage component by the eddy current is obtained from the output of the differential amplifier circuit 6. A high frequency signal from the oscillator circuit 4 is shifted by $\theta$ in the phase shifting circuit 7, and the pulse generating circuit 8 receiving the shifted signal generates a sampling pulse shown in Fig. 2 (d) which turns on the transistor 9 and the field effect transistor 10 by rendering a gate potential of the transistor 10 to a ground level. Accordingly, the output from the differential amplifier 6 is applied to the capacitor $C_2$ for charging through the field effect transistor 10. As the sampling pulse ceases, the transistor 10 turns off and the capacitor stops to be charged, so that the level charged in the capacitor $C_2$ is held for application to the comparator circuit 13 until a next sampling pulse is applied to the transistor 10. The comparator circuit 13 compares the output from the sampling circuit 12 with the reference level Vs. If the reference level Vs is higher than the output from the circuit (Fig. 2 (e)-section A), an high signal is not generated as shown in Fig. 2 (f) and the output transistor 14 is not turned on. When the output from the sampling circuit 12 goes over the reference level Vs (Fig. 2 (e)-point B), the comparator circuit 14 generates a high signal as shown in Fig. 2 (f) and the transistor 14 is turned on.

Thus, a phase component of a voltage by an eddy current is cancelled when no piece of metal approaches, but a phase component of a voltage by an eddy current to be detected is picked up by the phase shifting circuit, the pulse generating circuit and the sampling circuit to neglect other components, so that the S/N ratio is improved and the characteristics of this proximity switch is stable against variation of an external temperature.

According to the high frequency oscillation type proximity switch of this invention, not only the detection of approach of an object to be detected but also the characteristics of the object can be detected by selecting a phase shifted by the phase shifting circuit or a reference level for comparison by the comparator circuit in accordance with electrical and magnetical characteristics of the object.

While a preferred embodiment of this invention has been described and illustrated, it should be apparent that many modifications can be made without departing from the spirit and scope of this invention.

**Claims**

1. An oscillation type proximity switch for detecting a metal object to be detected thereby comprising;
an oscillator (4) for generating a high frequency signal,
sensing means (1, 2, 6) associated with said oscillator for generating an electrical sensing signal in accordance with an approach of the metal object,
pulse means (7, 8) associated with said oscillator for generating a predetermined cycle of pulse having a phase shifted by a predetermined phase angle from said high frequency signal,
sampling means (12) for sampling said electrical sensing signal in accordance with said predetermined cycle of pulse, and
comparator means (13) for comparing an output generated from said sampling means with a predetermined value to generate an output of detection.

2. An oscillation type proximity switch according to Claim 1 in which said sensing means (1, 2, 6) includes a pair of excitation and compensation coils (1, 2) energized by the high frequency signal from said oscillator, said compensation coil generating a voltage having a substantially same potential as that of a voltage generated from said excitation coil when the metal object does not approach.

3. An oscillation type proximity switch according to Claim 2 in which said sensing means further includes differential amplifier means (6) for receiving voltages generated from said excitation and compensation coils to be differentially amplified and for generating an output having a voltage in accordance with the voltage generated from said excitation coil by an eddy current flowing the metal object approaching the excitation coil.

4. An oscillation type proximity switch according to Claim 1 in which said pulse means (7, 8) includes phase shifting means (7) for shifting said high frequency signal generated from said oscillator by a predetermined phase angle and pulse generating means (8) for generating said predetermined cycle of pulse based on the shifted high frequency signal generated from said phase shifting means.

5. An oscillation type proximity switch according to Claim 1 in which said sampling means (12) further includes means ($C_2$) for holding said sampled electrical sensing signal.

# F I G. I

EP 0 316 914 A2

EP 0 316 914 A2

# FIG.2(a)
EXCITING VOLTAGE

# FIG.2(b)
VOLTAGE OF
COIL I
(METAL APPROACH)

# FIG.2(c)
OUTPUT OF
DIFFERENTIAL AMP.
(METAL NO-APPROACH)

# FIG.2(d)
SAMPLING PULSE

# FIG.2(e)
OUTPUT OF
SAMPLING CIRCUIT

# FIG.2(f)
OUTPUT OF
COMPARATOR
CIRCUIT

A

B

# FIG. 3